# EUROPEAN PATENT APPLICATION

(11) **EP 1 865 485 A2**
(43) Date of publication of application: **12.12.2007**
(21) Application number: 07252020.8
(22) Date of filing: 17.05.2007
(51) Int. Cl.: G09G 3/28

(54) **Plasma display apparatus and scan drive circuit with reduced effect of surge voltage**

(30) Priority: 08.06.2006 JP 2006159943
(71) Applicant: Fujitsu Hitachi Plasma Display Limited, Higashimorokata-gun Miyazaki 880-1194 (JP)
(72) Inventor: Igari, Yasuhito, Miyazaki 880-1194 (JP); Kanazawa, Yoshikazu, Miyazaki 880-1194 (JP); Tomio, Shigetoshi, Miyazaki 880-1194 (JP); Kumakura, Ken, Miyazaki 880-1194 (JP); Ohno, Taizo, Miyazaki 880-1194 (JP); Ohtaka, Hiroshi, Miyazaki 880-1194 (JP)
(74) Representative: Hackney, Nigel John

(57) **Abstract**

A plasma display apparatus includes a Y-electrode scan circuit (33) that has an IC (10) that operates with a power supply voltage, of which a difference between a ground potential and a power supply potential is substantially more than 50 V. A ceramic condenser (52) is disposed in a vicinity of the IC and coupled between the ground potential and the power supply potential of the IC, and a resistor (53) is connected in series with the ceramic condenser between the ground potential and the power supply potential. The ceramic condenser and the resistor constitute a filter circuit (51) which suppresses a surge voltage during scanning of the display.

## Description

The present invention generally relates to an image display apparatus and a display apparatus drive circuit, and particularly relates to a plasma display apparatus and a plasma display panel drive circuit.

A plasma display panel has two glass substrates which have electrodes formed thereon and define a space therebetween that is filled with discharge gas, and generates electric discharge by applying voltages between the electrodes so as to induce light emission from fluorescent substance provided on the substrates in response to the ultraviolet light generated by the electric discharge, thereby displaying an image. Plasma display panels are widely used as large-screen display apparatuses due to the facts that it is easy to make a large-sized screen, that its self-light- emission nature ensures high display quality, and that the response speed is high.

On a display panel, X electrodes and Y electrodes extending in parallel are formed, and address electrodes are provided to run perpendicularly to the X and Y electrodes. The X and Y electrodes serve to generate sustain discharges for display-purpose light emission. The sustain discharges are generated by applying voltage pulses repeatedly between the X electrodes and the Y electrode. The Y electrodes also serve as scan electrodes for use in the writing of display data. The address electrodes serve to select discharge cells that emit light, and apply address-voltage pulses responsive to display data in order to generate write discharge for selecting discharge cells between the Y electrodes and the address electrodes.

All that an X-electrode drive circuit for driving the X electrodes does is to supply the voltage for generating sustain discharge, so that the X-electrode drive circuit is implemented as a simple switch circuit comprised of MOSFETs. A Y-electrode drive circuit for driving the Y electrodes, on the other hand, not only supplies the voltage for generating sustain discharge, but also serves to scan the Y electrodes at the time of writing display data. The Y-electrode drive circuit is thus implemented by using scan ICs usable for the scanning purpose.

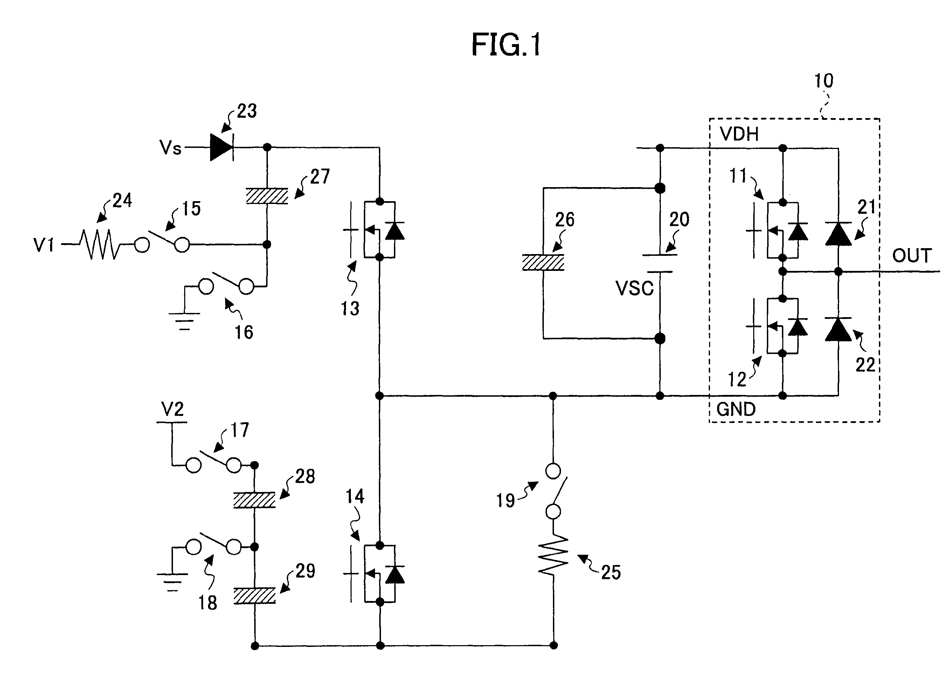

Fig. 1 is a drawing showing an example of the configuration of a related-art Y-electrode drive circuit. A Y-electrode drive circuit of Fig. 1 includes switches 11 through 19, a power supply 20, diodes 21 through 23, resistors 24 and 25, and condensers 26 through 29. Each switch shown in Fig. 1 is implemented by use of one or more MOSFETs. The ON/OFF control of each switch is performed by controlling a signal voltage applied to the gate node of the one or more MOSFETs.

A scan IC (scan integrated circuit) 10 includes the switch 11, the switch 12, the diode 21, and the diode 22. An output signal line OUT extending from the scan IC 10 is connected to a corresponding one of the Y electrodes. In reality, a plurality of sets each comprised of the switch 11, the switch 12, the diode 21, the diode 22, and the output signal line OUT are provided in a single scan IC 10, so that each scan IC 10 is capable of scanning a plurality of Y electrodes (e.g., 192 Y electrodes). The power supply 20 supplies a direct-current voltage VSC that is equal to Vs + V2. The electrolyte condenser 26 absorbs voltage fluctuation, so that the power supply voltage VDH of the scan IC 10 is maintained at the constant voltage VSC relative to GND. Here, GND is the ground-potential side of the scan IC 10. As will be described in the following, however, GND is not fixed to a ground potential, but is caused to vary in accordance with its expected operation. The voltage VSC is a high voltage higher than approximately 50V.

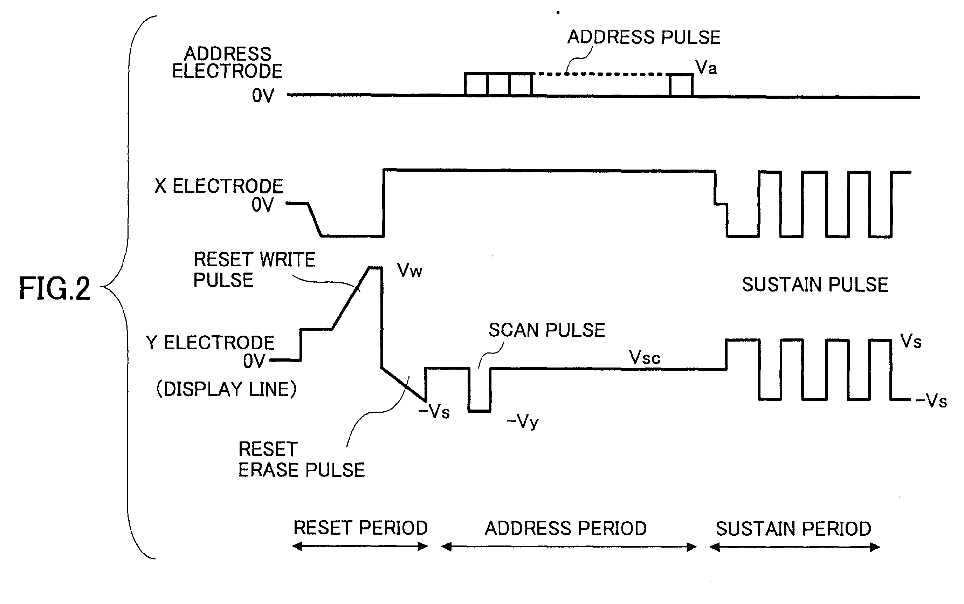

Fig. 2 is a drawing showing an example of waveforms for driving X electrodes, Y electrodes, and address electrodes. The drive period of a plasma display panel mainly consists of a reset period, an address period, and a sustain period. In the reset period, each display pixel is initialized. In the address period that follows, pixels to be displayed (i.e., pixels to emit light) is selected. In the sustain period that comes last, the selected pixels are caused to emit light.

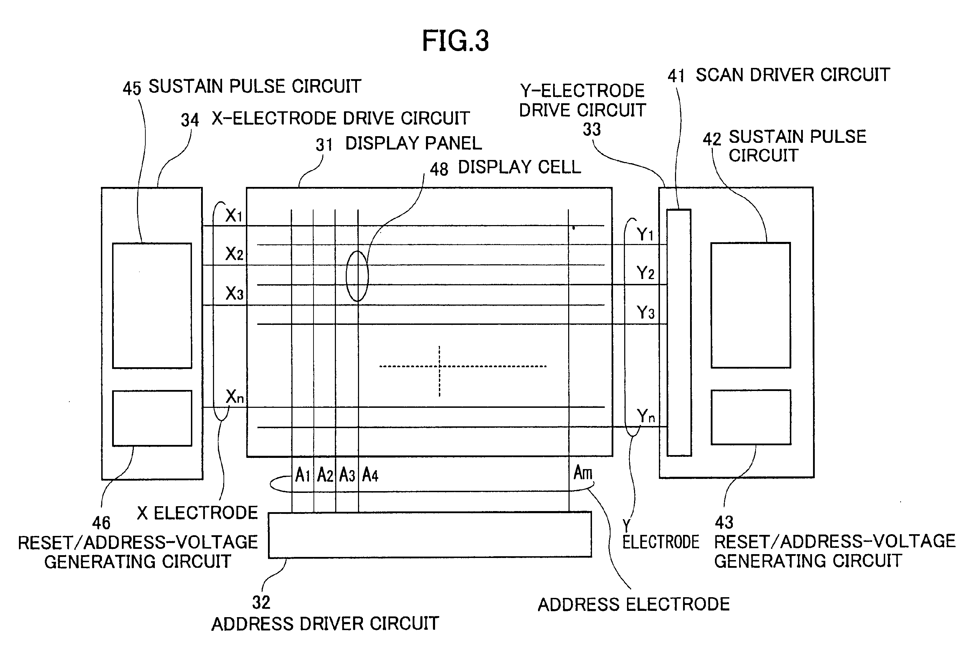

In the reset period, voltage waveforms as shown in Fig. 3 are applied to the Y electrodes serving as scan electrodes and to the X electrodes, thereby initializing the state of all the display cells. Namely, the cells that were displayed on a preceding occasion and the cells that were not displayed on the preceding occasion are equally initialized to the same state.

During this reset period, the switch 15 and the switch 13 are turned on, so that the voltage V1 + Vs is supplied to the scan IC 10 via the switch 13. In the scan IC 10, the received voltage V1 + Vs is supplied to the Y electrode of the panel via the diode 22 connected in parallel to the switch 12. In this manner, the voltage V1 + Vs is applied to all the Y electrodes provided in the panel. An electric current then flows from the panel to the ground via the switch 12, the switch 19, and the switch 18, thereby forming a reset erase pulse having a gentle slope reaching -Vs as shown in Fig. 2.

In the address period, scan voltage pulses at the -Vy level are successively applied to the Y electrodes serving as scan electrodes, thereby driving the Y electrodes one by one. In synchronization with the application of the scan voltage pulses to the Y electrodes, address voltage pulses at the Va level are applied to the address electrodes. This serves to select display cells on each scan line.

During this address period, the GND side of the scan IC 10 is fixed to -Vy (-(V2 + Vs)) in the circuit shown in Fig. 1, and either one of the switch 11 and the switch 12 is turned on to scan and drive the corresponding Y electrode. When a scan pulse is to be applied to the corresponding Y electrode, the switch 11 and the switch 12 are turned off and on, respectively, thereby outputting a -Vy pulse to the output signal line OUT. When a scan pulse is not being applied to the corresponding Y electrode, the switch 11 and the switch 12 are turned on and off, respectively, thereby keeping the output signal line OUT at VDH of the scan IC 10. During the address period, the switching operations of the switch 11 and switch 12 of the scan IC 10 control the application of a pulse to the Y electrode as described above, thereby making it possible to perform the driving of individual Y electrodes independently of each other.

In the sustain period that comes next, sustain pulses (sustain voltage pulses) at the common Vs level (Vs) are alternately supplied to all the Y scan electrodes and to all the X common electrodes. With this arrangement, the pixels selected in the address period are cause to emit light. The continuous application of sustain pulses then achieves a display at predetermined luminance levels.

During this sustain period, the switch 12 is kept in the ON state, and the switch 13 and the switch 14 are alternately turned on in the circuit shown in Fig. 1. In so doing, the switch 16 and the switch 18 are placed in the ON state. With this arrangement, a sustain pulse equal to voltage Vs and a sustain pulse equal to voltage -Vs are alternately output to the output signal line OUT.

It is known that when a plasma display panel is driven in the manner as described above, a serge voltage appears on the output signal line OUT due to a potential difference between the opposing electrodes of the panel and the like because the panel to be driven behaves as a capacitive load. The serge voltage appearing on the output signal line OUT ends up being superimposed on voltage VDH of the scan IC 10. As previously described, the voltage between VDH and GND of the scan IC 10 is designed to stay substantially at a constant level by way of the electrolyte condenser 26. After actual implementation, however, there is a certain distance between the electrolyte condenser 26 and the scan IC 10, so that the voltage is relatively free to change at a position that is distanced from the electrolyte condenser 26 via an interconnecting resistance. Because of this, a serge voltage appearing in a scan IC 10 positioned close to the electrolyte condenser 26 is small whereas a large serge voltage is superimposed on VDH in a scan IC 10 positioned far away from the electrolyte condenser 26.

VDH of the scan IC 10 is set to about 120 V above GND in a stable state, but may increase to approximately 150 V due to the serge voltage described above. The maximum tolerable voltage of the scan IC 10 is about 170 V. In some cases, VDS increases to a voltage close to such maximum tolerable voltage.

IC components may have their usable life shortened or suffer an increased failure rate if they are used in the condition where a voltage close to the maximum tolerable voltage (i.e., the limit voltage above which circuit destruction occurs) is applied. That is, they become more likely to fail when used in a stressful condition. If IC components are used in a low stress condition with an applied voltage much lower than the maximum tolerable voltage, on the other hand, they can be used for a long time with a low failure rate. Such reduction of stress is called derating. In order to provide sufficient derating to secure sufficient reliability with respect to circuit components in the scan IC 10, there is a need to address the serge voltage.

Reliability is conventionally ensured by using a high-tolerance-level scan IC 10 or by inserting a large film condenser close to the scan IC 10 for the purpose of eliminating a serge voltage. A high-tolerance-level scan IC 10 is expensive. The use of such scan ICs 10 leads to a price increase of plasma display panels. Further, the use of a large film condenser also leads to a cost increase, and also results in an increase in circuit size.

[Patent Document 1] Japanese Patent Application Publication No. 6-186927

Accordingly, the invention aims to provide a plasma display apparatus and a plasma display panel drive circuit in which the effect of serge voltage is reduced without increasing cost and circuit size.

Preferably, it is a general object of the present invention to provide a plasma display apparatus and a plasma display panel drive circuit that substantially obviate one or more problems caused by the limitations and disadvantages of the related art.

Features and advantages of the present invention will be presented in the description which follows, and in part will become apparent from the description and the accompanying drawings, or may be learned by practice of the invention according to the teachings provided in the description. Objects as well as other features and advantages of the present invention will be realized and attained by a plasma display apparatus and a plasma display panel drive circuit particularly pointed out in the specification in such full, clear, concise, and exact terms as to enable a person having ordinary skill in the art to practice the invention.

In a first aspect, the invention provides a plasma display apparatus which includes an IC that operates with a power supply voltage, of which a difference between a ground potential and a power supply potential is substantially more than 50 V, a ceramic condenser disposed in a vicinity of the IC and coupled between the ground potential and the power supply potential of the IC, and a resistor connected in series with the ceramic condenser between the ground potential and the power supply potential.

According to another aspect of the present invention, a drive circuit for successively scanning and driving first electrodes while third electrodes are driven in a display panel, in which display cells are constituted at least by a set of electrodes including the first electrodes extending in a first direction, second electrodes extending in the first direction, and the third electrodes extending in a second direction substantially perpendicular to the first direction, includes an IC configured to successively scan and drive the first electrodes by operating with a power supply voltage, of which a difference between a ground potential and a power supply potential is substantially more than 50 V, a ceramic condenser disposed in a vicinity of the IC and coupled between the ground potential and the power supply potential of the IC, and a resistor connected in series with the ceramic condenser between the ground potential and the power supply potential.

According to at least one embodiment of the present invention, a filter circuit comprised of the series connection of the ceramic condenser and the resistor is provided in a close proximity of the scan IC between VDH and GND to suppress a serge voltage, thereby making it possible to ensure the use of the scan IC in a low-stress-level condition at a voltage sufficiently lower than the maximum tolerable voltage. This achieves a circuit configuration ensuring sufficient derating and high reliability with respect to the scan IC by using a low-cost, small-size circuit.

### BRIEF DESCRIPTION OF THE DRAWINGS

Other objects and further features of the present invention will be apparent from the following detailed description when read in conjunction with the accompanying drawings, in which:
Fig. 1 is a drawing showing an example of the configuration of a related-art Y-electrode drive circuit;
Fig. 2 is a drawing showing an example of waveforms for driving X electrodes, Y electrodes, and address electrodes;
Fig. 3 is a block diagram showing a main part of a plasma display apparatus to which the present invention is applied;
Fig. 4 is a drawing showing an example of the configuration of the Y-electrode drive circuit according to the present invention;
Figs. 5A and 5B are drawings showing examples of voltage waveforms actually observed between VDH and GND; and
Fig. 6 is a drawing for explaining a variation of the Y-electrode drive circuit of the present invention.

### DESCRIPTION OF THE PREFERRED EMBODIMENTS

In the following, embodiments of the present invention will be described with reference to the accompanying drawings.

Fig. 3 is a block diagram showing a main part of a plasma display apparatus to which the present invention is applied. A plasma display apparatus shown in Fig. 3 includes a display panel 31, an address driver circuit 32, a Y-electrode drive circuit 33, and an X-electrode drive circuit 34. The Y-electrode drive circuit 33 includes a scan driver circuit 41, a sustain pulse circuit 42, and a reset/address-voltage generating circuit 43. The X-electrode drive circuit 34 includes a sustain pulse circuit 45 and a reset/address-voltage generating circuit 46. Each circuit shown in Fig. 3 is controlled by various control signals such as a clock signal, display data, a vertical synchronizing signal, and a horizontal synchronizing signal.

The address driver circuit 32 applies address-voltage pulses responsive to the display data to address electrodes A1 through Am in synchronization with the clock signal. The Y-electrode drive circuit 33 drives Y electrodes Y1 through Yn independently of each other. The X-electrode drive circuit 34 drives X electrodes X1 through Xn all together.

Waveforms for driving the address electrodes, Y electrodes, and X electrodes through the operations of the address driver circuit 32, the Y-electrode drive circuit 33, and the X-electrode drive circuit 34 are the same as those used in the related-art configuration as shown in Fig. 2, for example. In the reset period, each display pixel is initialized. In the address period that follows, pixels to be displayed (i.e., pixels to emit light) is selected. In the sustain period that comes last, the selected pixels are caused to emit light.

In the reset period, the reset/address-voltage generating circuit 43 of the Y-electrode drive circuit 33 generates a reset voltage, so that the scan driver circuit 41 applies the reset voltage to all the Y electrodes Y1 through Yn. Further, a reset voltage generated by the reset/address-voltage generating circuit 46 of the X-electrode drive circuit 34 is applied to all the X electrodes X1 through Xn.

In the address period, the scan driver circuit 41 drives the Y electrodes Y1 through Yn successively one by one based on the address voltage generated by the reset/address-voltage generating circuit 43, and, in conjunction therewith, the address driver circuit 32 applies address-voltage pulses for one horizontal line responsive to the display data to the address electrodes A1 through Am. Cells to be displayed are selected in this manner, thereby controlling the display/non-display (selection/non-selection) of each display cell (pixel) 48.

In the sustain period, sustain voltage pulses generated by sustain pulse circuit 42 are applied to the Y electrodes Y1 through Yn via the scan driver circuit 41, and sustain voltage pulses generated by the sustain pulse circuit 45 are applied to the X electrodes X1 through Xn from the X-electrode drive circuit 34. The application of these sustain voltage pulses generates sustain discharge between an X electrode and a Y electrode at the cells selected as display cells. The address electrodes A1 through Am, X electrodes X1 through Xn, and Y electrodes Y1 through Yn are disposed between a front glass substrate and a rear glass substrate of the display panel 31. Further, partition walls are provided between the address electrodes A1 through Am.

In the plasma display apparatus as described above, the number of light emissions of each display cell may be controlled to achieve the displaying of gray-scale tones. Electric discharge in the plasma display apparatus can assume only one of the two states, i.e., either the ON-state or the OFF-state, so that the number of light emissions is controlled to represent the level of brightness, i.e., gray-scale tones. To this end, one frame is divided into a plurality of sub-fields (e.g., 10 sub-fields). Each sub-field is constituted by a reset period, an address period, and a sustain period, and the length of the sustain period, i.e., the number of light emissions, is made to vary from sub-field to sub-field. For example, the ratio of the lengths of the sustain periods from the first sub-field to the tenth sub-field may be set to 1:2:4:8: ... :512. One or more sub-fields are selected and subjected to discharge in response to the gray-scale level of a cell to be displayed, thereby displaying the cell at the desired gray-scale level.

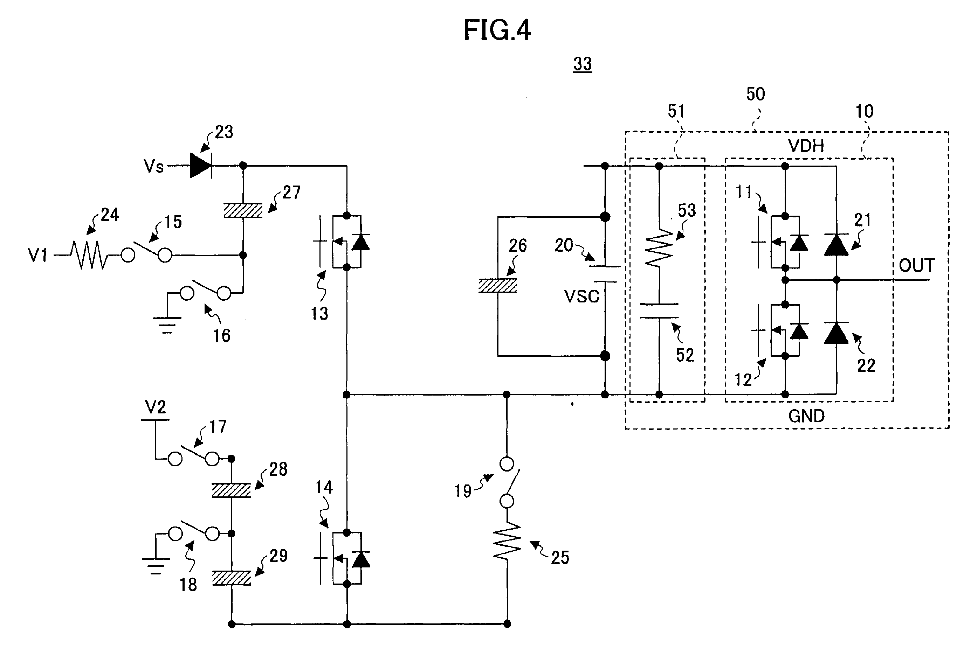

Fig. 4 is a drawing showing an example of the configuration of the Y-electrode drive circuit 33 according to the present invention. In Fig. 4, the same elements as those of Fig. 1 are referred to by the same numerals, and a description thereof will be omitted.

The Y-electrode drive circuit 33 of Fig. 4 includes a chip ceramic condenser 52 and a chip resistor 53 in addition to switches 11 through 19, a power supply 20, diodes 21 through 23, resistors 24 and 25, and condensers 26 through 29, which are the same as those shown in Fig. 1. The chip ceramic condenser 52 and the chip resistor 53 together constitute a filter circuit 51 for the purpose of suppressing a serge voltage.

As in the configuration shown in Fig. 1, a scan IC 10 includes the switch 11, the switch 12, the diode 21, and the diode 22. An output signal line OUT extending from the scan IC 10 is connected to a corresponding one of the Y electrodes. In reality, a plurality of sets each comprised of the switch 11, the switch 12, the diode 21, the diode 22, and the output signal line OUT are provided in a single scan IC 10, so that each scan IC 10 is capable of scanning a plurality of Y electrodes (e.g., 192 Y electrodes). The portion of the Y-electrode drive circuit 33 that is not implemented on a scan-drive-module substrate 50 is shared by all the Y electrodes.

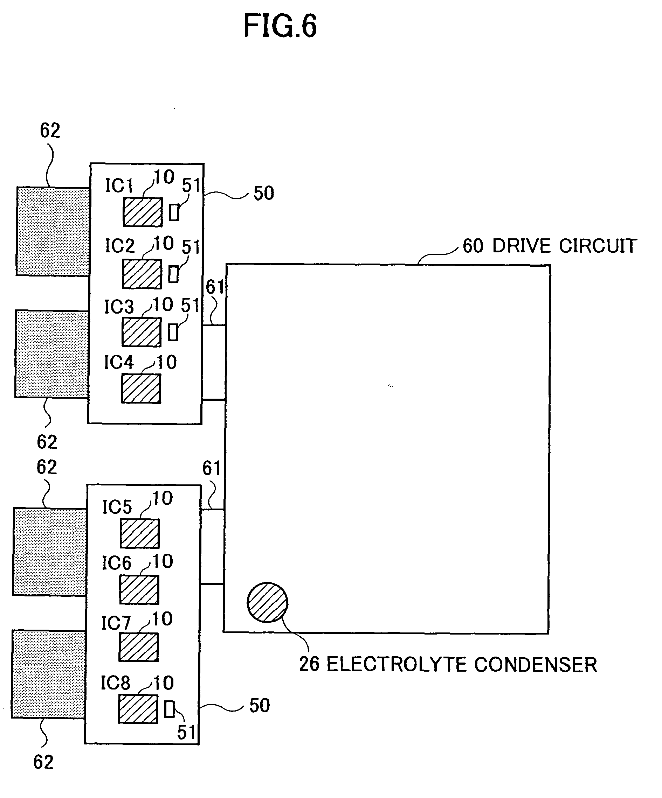

The scan IC 10 is implemented on the scan-drive-module substrate 50 (printed circuit board). Only one scan IC 10 is shown with respect to one scan-drive-module substrate 50 for the sake of convenience of illustration. In reality, however, a plurality of scan ICs 10 (see Fig. 6) are mounted on one scan-drive-module substrate 50.

The operations of the Y-electrode drive circuit 33 in the reset period, the address period, and the sustain period are the same as those described in connection with Fig. 1 and Fig. 2. In the reset period, the reset voltage is supplied to the scan ICs 10, and is applied to all the Y electrodes Y1 through Yn via paths provided in the scan ICs 10. During the address period, the switching operations of the switch 11 and switch 12 of the scan IC 10 control the application of a pulse to the Y electrode, thereby making it possible to perform the driving of individual Y electrodes independently of each other to apply a scan pulse to a successively selected one of the Y electrodes. In the sustain period, the sustain voltage is supplied to the scan ICs 10, and is applied to all the Y electrodes Y1 through Yn via paths provided in the scan ICs 10.

When a plasma display panel is driven in the manner as described above, a serge voltage appears on the output signal line OUT due to a potential difference between the opposing electrodes of the display panel 31 and the like because the panel to be driven behaves as a capacitive load. The serge voltage appearing on the output signal line OUT ends up being superimposed on voltage VDH of the scan IC 10.

In order to suppress this serge voltage, the Y-electrode drive circuit 33 of Fig. 4 includes the chip ceramic condenser 52 and the chip resistor 53 situated in a close vicinity of the scan IC 10 on the scan-drive-module substrate 50, and are inserted between VDH and GND of the scan IC 10. With this arrangement, the filtering effect of the filter circuit 51 comprised of the chip ceramic condenser 52 and the chip resistor 53 prevents VDH from reaching a high voltage level significantly exceeding its stable-state voltage level due to the superimposition of a serge voltage appearing on the output signal line OUT. Namely, the integration effect of the chip ceramic condenser 52 serves to smooth a steep waveform of the serge voltage, thereby suppressing an increase in VDH.

However, there is a possibility of the chip ceramic condenser 52 being destroyed to result in a short-circuit state if an excessively large serge voltage is applied. The chip resistor 53 connected in series with the chip ceramic condenser 52 between VDH and GND is thus designed to have such a resistance that the resistor is destroyed in response to an excessive electric current responsive to such an excessive voltage. Namely, provision is made such that the chip resistor 53 is destroyed to result in an open-path state before the chip ceramic condenser 52 is destroyed to result in a short-circuit state. With this provision, the scan IC 10 is prevented from becoming incapable of operation by avoiding short-circuiting between VDH and GND even if an excessively large serge voltage is applied.

There has been a conventional configuration in which a large film condenser is inserted between VDH and GND as previously described. No configuration, however, is known in which a ceramic condenser is inserted. This is because a ceramic condenser has a low tolerance level whereas a film condenser has a high, superior tolerance level. Under the conditions in which a high voltage such as 120 V in a stable state and reaching even 150 V due to a serge voltage is applied as between VDH and GND, it was conventionally an inevitable choice to use a film condenser that would be unlikely to be destroyed because of its high, superior tolerance level. The use of a ceramic condenser having a low tolerance level is fraught with a danger of destruction, which would result in a short-circuit state that incapacitates the operation of the scan IC 10.

In the present invention, a series connection of a ceramic condenser and a resistance is used to provide a configuration that provides an open-path state upon destruction, thereby making it viable to use a ceramic condenser. A ceramic condenser as used in the present invention is inexpensive compared with a film condenser that was conventionally used, thereby helping to achieve cost reduction.

It should be noted that there is no chipshape film condenser, and all film condensers are of the type that has connection nodes extending from a disc portion. Conventionally, a film condenser the size of a 2-cm=x-2-cm square, for example, is used for the serge-voltage suppressing purpose. The chip ceramic condenser 52 used in the present invention, on the other hand, is a ceramic condenser having a chip shape with a laminated structure, and may have a size of 2 mm by 1.25 mm, for example. The use of the chip ceramic condenser 52 thus helps to reduce the circuit size. Further, with chip shape, a stress applied to the condenser is small at the time of mounding on a substrate, thereby lowering the possibility of the component being damaged.

In this manner, the present invention uses the filter circuit 51 comprised of a series connection of the chip ceramic condenser 52 and the chip resistor 53 that is positioned in a close proximity of the scan IC 10 between VDH and GND to suppress a serge voltage, thereby making it possible to ensure the use of the scan IC 10 in a low-stress-level condition at a voltage sufficiently lower than the maximum tolerable voltage. This achieves a circuit configuration ensuring sufficient derating and high reliability with respect to the scan IC 10 by using a low-cost, small-size circuit.

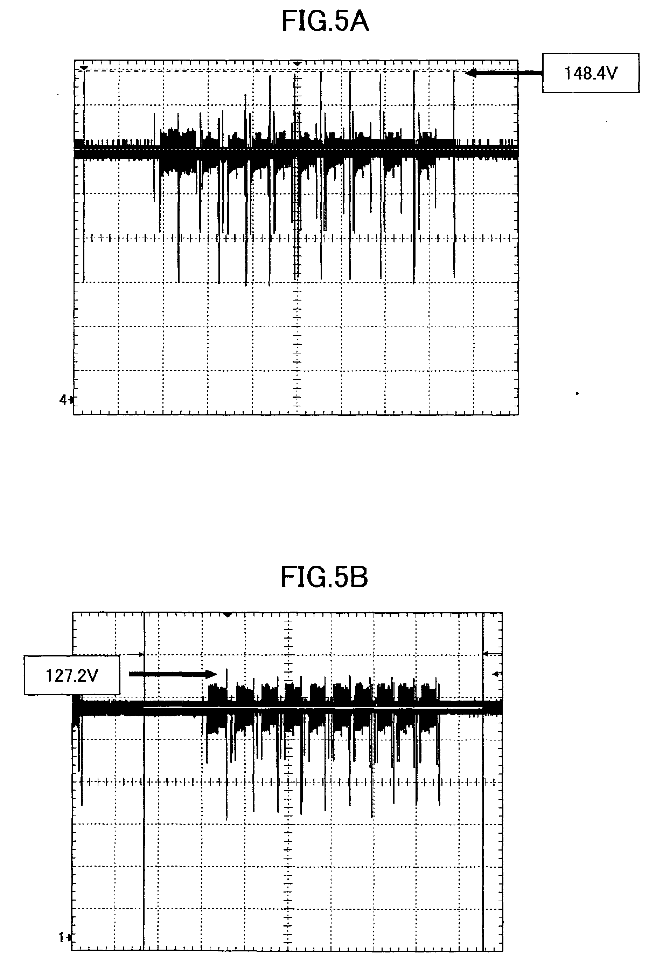

Figs. 5A and 5B are drawings showing examples of voltage waveforms actually observed between VDH and GND. Fig. 5A illustrates the way a voltage between VDH and GND changes during a sustain period in the related-art Y-electrode drive circuit (Fig. 1). Fig. 5B illustrates the way a voltage between VDH and GND changes during a sustain period in the Y-electrode drive circuit (Fig. 4) according to the present invention.

In the operation of the related-art Y-electrode drive circuit shown in Fig. 5A, a serge voltage is superimposed so that a voltage reaching 148.4 V at its peak is generated. In the operation of the Y-electrode drive circuit 33 of the present invention shown in Fig. 5B, on the other hand, the filter circuit 51 comprised of the chip ceramic condenser 52 and the chip resistor 53 suppresses a serge voltage, so that the maximum peak voltage is only 127.2 V. With the insertion of the filter circuit 51 of the present invention as described above, thus, a serge voltage is reliability suppressed, thereby making it possible to operate the scan IC 10 in conditions that ensure reliability.

Fig. 6 is a drawing for explaining a variation of the Y-electrode drive circuit 33 of the present invention. What is shown in Fig. 6 is a configuration of the Y-electrode drive circuit 33 as actually implemented on circuit boards. Among the portions constituting the Y-electrode drive circuit 33 shown in Fig. 4, the portions other than the scan IC 10 and the filter circuit 51 implemented on the scan-drive-module substrate 50 are shown as a drive circuit 60.

In Fig. 6, various voltages and voltage pulses generated by the drive circuit 60 for the reset purpose, address-scan purpose, and sustain- discharge purpose are supplied to a plurality of scan ICs 10 implemented on scan-drive-module substrates 50 via board connectors 61. Two scan-drive-module substrates 50 are connected to one drive circuit 60, and four scan ICs 10 are mounted on each scan-drive-module substrate 50. In this configuration, the number of Y electrodes driven by each scan IC 10 is 192, so that a total of 1536 Y electrodes are driven. The output signal lines of the scan ICs 10 are connected to the Y electrodes Y1 through Yn of the display panel 31 via flexible cables 62.

One electrolyte condenser 26 as shown in Fig. 4 is provided in the drive circuit 60. The power supply 20 charges the electrolyte condenser 26 provided in the drive circuit 60 with the voltage VSC, and the charged voltage is supplied to each scan IC 10 from the electrolyte condenser 26. Each of such supply paths extends from the electrolyte condenser 26 and passes through the drive circuit 60 and one of the board connectors 61 to reach a scan IC 10 through an interconnect provided on the scan-drive-module substrate 50.

As previously described, a serge voltage appearing as superimposed on VDH of the scan IC 10 differs depending on the distance between the electrolyte condenser 26 and a scan IC 10, i.e., depending on the length of the above-described supply path. The serge voltage is relatively small in a scan IC 10 that is positioned at a short distance from the electrolyte condenser (voltage supply source) 26, i.e., in a scan IC 10 that has a short supply path. On the other hand, the serge voltage is relatively large in a scan IC 10 that is positioned at a long distance from the electrolyte condenser (voltage supply source) 26, i.e., in a scan IC 10 that has a long supply path.

In an example shown in Fig. 6, IC4, IC5, IC6, and IC7 among the 8 scan ICs 10 are positioned at relatively short distances from the electrolyte condenser 26, so that the serge voltage is relatively small. IC1, IC2, IC3, and IC8, for example, are positioned at a relatively long distance from the electrolyte condenser 26, so that the serge voltage is relatively large. In such a case, provision may be made such that the filter circuit 51 of the present invention is provided only with respect to IC1, IC2, IC3, and IC8, i.e., with respect to the scan ICs 10 that are positioned at long distances from the electrolyte condenser 26 and suffer relatively large serge voltages. With the filter circuit 51 inserted between VDH and GND in these scan ICs 10, a serge voltage is suppressed in IC1, IC2, IC3, and IC8. Since serge voltages are relatively small with respect to IC4, IC5, IC6, and IC7, these ICs can be driven in a condition in which a sufficient margin is provided (to ensure sufficient derating) even without the filter circuit 51.

In this manner, the filter circuit 51 may be provided only with respect to some scan ICs 10 that are positioned at relatively long distances from the electrolyte condenser 26 among all the scan ICs 10. This can further reduce the cost and circuit size compared with a case in which the filter circuit 51 is provided in all the scan ICs 10. If a serge voltage is not ignorable in the scan ICs 10 (e.g., IC4, IC5, IC6, and IC7 in the example shown in Fig. 6) that are positioned at short distances from the electrolyte condenser 26, the filter circuit 51 may be provided in all the scan ICs 10 (i.e., IC1, IC2, IC3, IC4, IC5, IC6, IC7, and IC8).

Further, the present invention is not limited to these embodiments, but various variations and modifications may be made without departing from the scope of the present invention.

Although the embodiments described above have been directed to a configuration in which the filter circuit is provided in a scan IC of the Y-electrode drive circuit, the present invention is not limited to its application to a scan IC of the Y-electrode drive circuit. When a given IC is used in a condition where a high power supply voltage exceeding approximately 50 V is applied with a superimposed serge voltage, the filter circuit of the present invention can be utilized regardless of the type of the IC to suppress the serge voltage.

## Claims

1. A plasma display apparatus, comprising an IC that operates with a power supply voltage, of which a difference between a ground potential and a power supply potential is substantially more than 50 V, **characterized in that**
a ceramic condenser is disposed in a vicinity of the IC and coupled between the ground potential and the power supply potential of the IC, and
a resistor is connected in series with the ceramic condenser between the ground potential and the power supply potential.

2. The plasma display apparatus as claimed in claim 1, further comprising:
a display panel in which display cells are constituted at least by a set of electrodes including first electrodes extending in a first direction, second electrodes extending in the first direction, and third electrodes extending in a second direction substantially perpendicular to the first direction;
a first driver circuit configured to drive the first electrodes;
a second driver circuit configured to drive the second electrodes; and
a third drive circuit configured to drive the third electrodes while the first drive circuit successively scans and drives the first electrodes,
wherein the IC is a circuit that is embedded in the first driver circuit and configured to successively drive the first electrodes.

3. The plasma display apparatus as claimed in claim 2, further comprising a substrate on which the IC is mounted, wherein the ceramic condenser and the resistor are mounted on the substrate:

4. The plasma display apparatus as claimed in claim 2, further comprising an electrolyte condenser coupled between the ground potential and the power supply potential of the IC to supply the power supply voltage for driving the IC.

5. The plasma display apparatus as claimed in claim 4, further comprising a second IC identical to a first IC that is the IC of claim 1, wherein the ground potential and the power supply potential of the second IC are connected to the electrolyte condenser, with no ceramic condenser coupled between the ground potential and the power supply potential of the second IC, an interconnect distance between the second IC and the electrolyte condenser being shorter than an interconnect distance between the first IC and the electrolyte condenser.

6. The plasma display apparatus as claimed in claim 1, wherein the ceramic condenser is a chip laminated-type ceramic condenser

7. The plasma display apparatus as claimed in claim 1, wherein the resistor is a chip resistor.

8. The plasma display apparatus as claimed in claim 1, wherein the resistor is configured to be destroyed in response to an electric current that is tolerable to and does not destroy the ceramic condenser.

9. A drive circuit for successively scanning and driving first electrodes while third electrodes are driven in a display panel in which display cells are constituted at least by a set of electrodes including the first electrodes extending in a first direction, second electrodes extending in the first direction, and the third electrodes extending in a second direction substantially perpendicular to the first direction, the drive circuit comprising an IC configured to successively scan and drive the first electrodes by operating with a power supply voltage, of which a difference between a ground potential and a power supply potential is substantially more than 50 V, **characterized in that**
a ceramic condenser is disposed in a vicinity of the IC and coupled between the ground potential and the power supply potential of the IC, and
a resistor is connected in series with the ceramic condenser between the ground potential and the power supply potential.

10. The circuit as claimed in claim 9, further comprising a substrate on which the IC is mounted, wherein the ceramic condenser and the resistor are mounted on the substrate.
